# EUROPÄISCHE PATENTSCHRIFT

(11) **EP 3 428 835 B1**
(45) Veröffentlichungstag und Bekanntmachung des Hinweises auf die Patenterteilung: **15.05.2019**
(21) Anmeldenummer: 17181248.0
(22) Anmeldetag: 13.07.2017
(51) Int. Cl.: G06K 7/14

(54) **VERFAHREN ZUM LESEN EINES OPTISCHEN CODES**
METHOD FOR READING AN OPTICAL CODE
PROCÉDÉ DE LECTURE D'UN CODE OPTIQUE

(43) Veröffentlichungstag der Anmeldung: 16.01.2019
(73) Patentinhaber: Sick AG, 79183 Waldkirch (DE)
(72) Erfinder: Schüler, Pascal, 79331 Teningen (DE)

(56) Entgegenhaltungen:
- US-A- 5 553 084
- US-A- 5 880 451
- US-B1- 6 330 972

## Beschreibung

Die Erfindung betrifft ein Verfahren zum Lesen eines optischen Codes nach dem Oberbegriff von Anspruch 1.

Codeleser sind von Supermarktkassen, zur automatischen Paketidentifikation, Sortierung von Postsendungen, von der Gepäckabfertigung in Flughäfen und aus anderen Logistikanwendungen bekannt. In einem Codescanner wird ein Lesestrahl mittels eines Drehspiegels oder eines Polygonspiegelrads quer über den Code geführt. Ein kamerabasierter Codeleser nimmt mittels eines Bildsensors Bilder der Objekte mit den darauf befindlichen Codes auf, und eine Bildauswertungssoftware extrahiert aus diesen Bildern die Codeinformation.

In einer wichtigen Anwendungsgruppe werden die Code tragenden Objekte an dem Codeleser vorbei gefördert. Ein scannender Codeleser erfasst dabei die jeweils nacheinander in seinen Lesebereich geführten Codes. Alternativ liest in einem kamerabasierten Codeleser eine Zeilenkamera die Objektbilder mit den Codeinformationen sukzessive und zeilenweise mit der Relativbewegung ein. Mit einem zweidimensionalen Bildsensor werden regelmäßig Bilddaten aufgenommen, die sich je nach Aufnahmefrequenz und Fördergeschwindigkeit mehr oder weniger überlappen. Damit die Objekte in beliebiger Orientierung auf dem Förderer angeordnet werden können, sind oft mehrere Codeleser an einem Lesetunnel vorgesehen, um Objekte von mehreren oder allen Seiten aufzunehmen. Auch ein scannender Codeleser erfasst die Remission und damit letztlich Bildzeilen, die zu einem Objektbild zusammengefügt werden können, auch wenn hierfür in der Praxis ein Bildsensor vorgezogen wird. In einem solchen Objektbild können Codebereiche identifiziert und ein- oder zweidimensionale Codes ausgelesen werden.

Für einen Codeleser oder einen Lesetunnel stellt eine hohe Leserate eines der wichtigsten Qualitätskriterien dar. Lesefehler zwingen zu aufwändigen Fehlerbehebungen, wie dem erneuten manuellen Abscannen oder einer Nachsortierung.

Um Lesefehler zu vermeiden, sind herkömmliche Decoder insbesondere für zweidimensionale Codes wie DataMatrix, QR, Aztec, Maxicode, Dot-Code oder auch Stapelcodes wie PDF417 und MicroPDF mit einer Reed-Solomon-Korrektur ausgestattet, die es ermöglicht, eine gewisse Anzahl von Fehlern zu korrigieren. Die Ursache für solche Fehler kann in der Qualität des Codes selbst liegen, in einer ungünstigen Lesesituation wie unter einer Folie, die Reflexe verursacht, und schließlich auch in Auswertungsfehlern beispielsweise bei der Binarisierung von Grauwerten oder ungenau berechneten Abtastpositionen.

In der Codewortsequenz eines Reed-Solomon-Codes sind zusätzlich zu den Datenwörtern mit der eigentlichen Codeinformation auch Korrekturcodewörter vorgesehen, von denen eines für die Lokalisierung der Fehlerposition und ein zweites für die Korrektur des fehlerhaften Wertes benötigt werden. Die Anzahl der Korrekturcodewörter ist durch die Spezifikation des Codetyps vorgegeben. Das beschränkt dementsprechend die Anzahl höchstens korrigierbarer Fehler. Die Korrekturkapazität ist jeweils abhängig von der Symbolgröße des Codes und bei einigen Codetypen wie QR und PDF417 auch vom verwendeten Error-Level. Der Error-Level wird dabei vom Erzeuger des Codes im Encoding-Prozess festgelegt.

Sind also mehr Fehler in der Codewortsequenz vorhanden als mittels Reed-Solomon korrigiert werden können beziehungsweise ist die Korrekturkapazität überschritten, so kann der Code nicht mehr gelesen werden, und dem Decoder bleibt nichts anderes übrig, als ein Scheitern (NoRead) oder etwas spezifischer einen Reed-Solomon-Fehler zurückzugeben.

Als eine denkbare Ursache für Lesefehler wurde schon die Binarisierung genannt. Es gibt im Stand der Technik den als Weak-Bit-Algorithmus bezeichneten Ansatz, der Reed-Solomon-Korrektur eine Modifikation in dem Versuch vorzuschalten, die Reed-Solomon-Kapazität zu übertreffen. Dabei werden in einem Brute-Force-Verfahren Abtastpunkte identifiziert, deren Grauwerte nahe am Binarisierungsschwellwert liegen und an denen somit fraglich ist, ob das Modul hinsichtlich seiner Polarität korrekt klassifiziert werden konnte. Die Binarisierungsergebnisse an solchen als kritisch eingestuften Modulen werden dann durchpermutiert, und zu jeder Permuation wird jeweils erneut ein Decodierversuch mit der Reed-Solomon-Korrektur unternommen. Das Ziel ist, durch systematisches Probieren die richtige Kombination zu finden, in welcher der Code gelesen werden kann, ohne die Reed-Solomon Korrektur-Kapazität zu überschreiten.

Dieses Vorgehen ist aufgrund der blinden Permutation laufzeitkritisch. Außerdem sind durch das weitgehend wahllose Ausprobieren zumindest bei geringen Symbolgrößen auch Falschlesungen (Misreads) möglich, vor allem bei fälschlich als Codebereich erkannten Texturen. Ohnehin können nur Binarisierungsfehler korrigiert werden, nicht jedoch andere Lesefehler, deren Ursache schon vor der Auswertung in der Codeerfassung liegt, etwa Zerstörungen im Datenbereich durch Reflexe einer Folie über dem Code.

Folglich gibt es im Stand der Technik keine zufriedenstellende Möglichkeit, die Kapazität der Reed-Solomon Korrektur zu übertreffen.

Die US 5 553 084 offenbart eine Erweiterung einer Fehlerkorrektur für bestimmte Codetypen. Bei diesen Codetypen sind Füllsequenzen mit einem sogenannten Pad Character vorgesehen. Wenn nun ein Code nicht gelesen werden kann, wird nach einem Bereich mit einer Füllsequenz gesucht, und dort werden korrekte Pad Character überschrieben. Sofern der Lesefehler auf einem defekten Pad Character innerhalb einer Füllsequenz beruhte, ist dann ein anschließender weiterer Leseversuch erfolgreich.

In der US 5 880 451 wird ein OCR-unterstütztes Barcodelesen vorgestellt. Kann der Decoder ein Barcodesymbol nicht lesen, so wird stattdessen mittels OCR ein Text neben dem Barcode gelesen und das Barcodesymbol durch das entsprechende Textzeichen ersetzt. Ein abschließender Checksummenvergleich nach Lesen des gesamten Barcodes prüft implizit mit, ob die Ersetzung zulässig war.

Daher ist Aufgabe der Erfindung, ein noch verlässlicheres und robusteres Verfahren zum Lesen von optischen Codes anzugeben.

Diese Aufgabe wird durch ein Verfahren zum Lesen eines optischen Codes nach Anspruch 1 sowie einen entsprechenden Codeleser nach Anspruch 11 gelöst. Zunächst werden auf einem der bekannten Wege Bilddaten des optischen Codes aufgenommen und darin vorzugsweise durch eine Vorverarbeitung Codebereiche aufgefunden, welche die Bilddaten beispielsweise anhand des Kontrasts segmentiert. Dann werden die Codewörter ausgelesen. Der Code enthält außer den eigentlichen Daten noch weitere Prüfinformationen. Diese zusätzliche Information, etwa mit einer Checksumme oder einem Korrekturdatenwort, werden genutzt, um mit einem Prüfverfahren festzustellen, ob der Code richtig gelesen wurde. Das Prüfverfahren kann sich an das Lesen des Codes anschließen, oder Decodieren und Prüfen sind ein einheitliches Verfahren.

Die Erfindung geht von dem Grundgedanken aus, eine Vorkorrektur durchzuführen, in der an mindestens einer Position des Codes ein Codewort ersetzt wird, und zwar durch ein Codewort, von dem bekannt ist, dass es an diese Position gehört. Das beruht auf Vorwissen an das bekannte Codewort. Ob in dem aktuell gelesenen Code tatsächlich an dieser Position das bekannte Codewort steht, ist zunächst im Rahmen der Vorkorrektur nur eine Annahme. Die Ersetzung mit einem bekannten Codewort kann an einer Position, an mehreren Positionen oder sogar an allen Positionen erfolgen, für die ein Codewort bekannt ist. Es ist auch denkbar, Kombinationen auszuprobieren, sowohl hinsichtlich der Position als auch der für die Position bekannten Codewörter. Das hat aber Auswirkungen auf die Laufzeit, und zudem hängt die Wahrscheinlichkeit für ein korrektes Lesen davon ab, wie sicher das Vorwissen über ein bestimmtes bekanntes Codewort an einer Position ist, so dass es vorzugsweise nur jeweils einen Kandidaten für ein bekanntes Codewort an einer Position gibt und jedenfalls nur wenige.

Nach der Vorkorrektur mit dem Ersetzen mindestens eines Codeworts wird mit dem Prüfverfahren festgestellt, ob der Code nun richtig gelesen ist oder gelesen werden kann. Das kann der erste Leseversuch für diesen Code sein, in dem das zuvor unbekannte Leseergebnis an einer Position von Anfang an durch das bekannte Codewort ersetzt wird. Es kann lediglich die Überprüfung eines durch die Vorkorrektur modifizierten früheren Leseergebnisses etwa anhand einer Checksumme sein, ohne erneut zu decodieren. Vorzugsweise umfasst das Prüfverfahren einen wiederholten Leseversuch. Das betrifft dann den besonders relevanten Fall, dass sich trotz Ersetzen mit einem bekannten Codewort an anderen Positionen noch Fehler befinden, die dann in einem nachfolgenden Leseversuch korrigiert werden können, weil durch das Ersetzen nun die Korrekturkapazität des Prüfverfahrens ausreicht.

Die Erfindung hat den Vorteil, dass die Leserate weiter gesteigert werden kann. Aufgrund der Vorkorrektur können zumindest manche Codes trotz Zerstörungen oder Defekten noch gelesen werden, bei denen sonst selbst ein Leseverfahren mit Fehlerkorrektur wegen Überschreitung der Korrekturkapazität scheitert. Es gibt im Gegensatz zu herkömmlichen Brute-Force-Ansätzen mit Durchpermutieren von möglichen Codewörtern keine kritischen Laufzeiteinbußen, da vorzugsweise nur eine einzige Vorkorrektur stattfindet und jedenfalls nur eine überschaubare Anzahl von Versuchen notwendig ist. Die Gefahr von Misreads bleibt dabei gering. Das hängt davon ab, wie sicher das Vorwissen über die bekannten Codewörter ist. Vorzugsweise wird dies aus einer Historie zuvor gelesener Codes gewonnen und ist dann empirisch belegt. Den Vertrauenslevel kann man durch Forderungen in der Anwendung einstellen, in welcher Weise Codewörter wiederholt vorkommen müssen, ehe sie als bekannt gelten können. Außerdem erkennt das Prüfverfahren, ob der Code insgesamt zuverlässig erkannt ist.

Die Vorkorrektur wird bevorzugt erst durchgeführt, wenn zuvor laut Prüfverfahren der Code nicht gelesen werden konnte. Es gibt also zunächst einen Leseversuch ohne Vorkorrektur. Wenn damit der Code gemäß dem Prüfverfahren korrekt gelesen werden konnte, ist dieser Lesevorgang abgeschlossen. Ansonsten wird die Vorkorrektur durchgeführt und dann das modifizierte Leseergebnis erneut geprüft oder ein neuer Leseversuch auf Basis des Ergebnisses mit Vorkorrektur unternommen.

Das Prüfverfahren korrigiert vorzugsweise Lesefehler. Es wird also nicht lediglich der gelesene Code auf Richtigkeit geprüft, sondern die redundante Information oder die Korrekturcodewörter werden genutzt, um nicht oder falsch gelesene Codewörter zu korrigieren. Die Vorkorrektur erweitert das Korrekturverfahren des Prüfverfahrens, d.h. ermöglicht zumindest in einigen Fällen eine Korrektur auch dann noch, wenn das Prüfverfahren allein das nicht mehr leisten könnte. Damit hilft die Vorkorrektur, die Korrekturkapazität des Prüfverfahrens zu übertreffen.

Das Prüfverfahren weist bevorzugt eine Reed-Solomon-Fehlerkorrektur auf. Eine Fehlerkorrektur des Leseverfahrens muss natürlich von dem verwendeten Codetyp auch unterstützt werden. Dabei ist die Reed-Solomon-Fehlerkorrektur für zahlreiche gängige Codetypen weit verbreitet, von denen einleitend einige genannt sind. Diese Verbreitung hat auch ihre Gründe, denn Reed-Solomon ist bewährt und robust. Durch die Vorkorrektur steigt die Möglichkeit, sogar noch Codes mit starken Zerstörungen oder Defekten zu decodieren, bei denen selbst die Reed-Solomon-Korrekturfähigkeit nicht mehr ausreicht. Die Erfindung nutzt aber außer der abstrakten Fähigkeit zur Korrektur von Codewörtern keine spezifischen Eigenschaften von Reed-Solomon und ist daher nicht darauf beschränkt, soweit ein anderes Korrekturverfahren für zu lesende Codes zur Anwendung kommt.

Bevorzugt wird für den Fall, dass das Prüfverfahren ein in der Vorkorrektur ersetztes bekanntes Codewort an einer Position korrigieren muss, dieses bekannte Codewort für diese Position nicht länger als bekannt angesehen. Damit wird dem Vorwissen über das bekannte Codewort an dieser Position nicht länger vertraut. Das ist sinnvoll in Ausführungsformen, in denen besonders hohe Anforderungen an die Verlässlichkeit der bekannten Codewörter gestellt werden. Sofern für die Vorkorrektur nicht die Bedingung gestellt ist, dass ein bekanntes Codewort zumindest für die unmittelbare Vergangenheit immer und in jedem Code an seiner Position vorkommen muss, kann das bekannte Codewort trotz der Korrektur durch das Prüfverfahren für nachfolgende Lesevorgänge auch weiterverwendet werden.

Bekannte Codewörter und deren Positionen werden bevorzugt aus einer Historie von gelesenen Codes eingelernt. Es wird demnach eine Vielzahl von Codes gelesen, vorzugsweise nacheinander in derselben Anwendung, und dies bildet die Historie von gelesenen Codes, aus denen Schlüsse für bekannte Codewörter gezogen werden. Alternativ zu einem Einlernen aus der Historie ist auch denkbar, die bekannten Codewörter anders vorzugeben oder zu parametrieren. So kann bekannt sein, dass ein Teil der Codewörter in einer Anwendung immer oder zumindest zeitweise dieselbe Information trägt, wie ein Herstellerkürzel oder eine Chargennummer. Denkbar wäre, das Lesen der Codes mit einem Datenbanksystem abzugleichen, um derartige fixe Bestandteile der zu lesenden Codes abzugleichen und aktuell zu halten.

Ein Codewort wird bevorzugt als für eine Position bekannt angenommen, wenn es in der Historie mindestens einmal an der Position vorkommt. Für die Vorkorrektur ergibt sich daraus ein Fundus an Codewörtern, die an der jeweiligen Position schon einmal vorgekommen sind. Diese Bedingung ist schwach, es kann also gut sein, dass die Vorkorrektur mit einem Codewort ersetzt, das an dessen Position nicht gehört. Das Prüfverfahren bildet ein Filter gegen derart falsch ersetzte bekannte Codewörter.

Ein Codewort wird noch bevorzugter als für eine Position bekannt angenommen, wenn es in der Historie mindestens n-mal an der Position vorkommt. Je nachdem, wie groß n im Vergleich zu der gesamten Historie ist, wird es entsprechend wahrscheinlicher, dass das an der jeweiligen Position zu ersetzende Codewort im aktuellen Code tatsächlich das bekannte Codewort ist.

Ein Codewort wird bevorzugt als für eine Position bekannt angenommen, wenn es sich in der Historie mindestens n-mal an der Position wiederholt. Bei diesem noch schärferen Kriterium muss das Codewort sich wiederholen, also ununterbrochen hintereinander n-mal gelesen werden. Mit höheren Anforderungen an bekannte Codewörter steigt die Wahrscheinlichkeit, dass die Vorkorrektur ein Lesen des richtigen Codeinhalts ermöglicht. Dafür stehen aber auch weniger Möglichkeiten für eine Vorkorrektur zur Verfügung, insbesondere wenn sich in der Historie Codewörter nur selten oder gar nicht n-mal wiederholen.

Ein Codewort wird bevorzugt als für eine Position bekannt angenommen, wenn direkt zuvor ein anderer Code mit diesem Codewort an dieser Position gelesen wurde. Hier wird folglich die unmittelbare Historie betrachtet und verlangt, dass direkt vor dem aktuellen Leseversuch an der Position des bekannten Codeworts nichts anderes gelesen wurde, und zwar insbesondere in Kombination mit den schon genannten Kriterien mindestens für den direkt zuvor gelesenen Code, vorzugsweise ununterbrochen für die n unmittelbar zuvor gelesenen Codes.

Die Vorkorrektur wird bevorzugt nur durchgeführt, wenn an mindestens einer Position ein Codewort bekannt ist. Solange für keine Position ein bekanntes Codewort durch Einlernen aus der Historie oder aus anderer Quelle vorliegt, findet demnach keine Vorkorrektur statt. Vorzugsweise muss die Einlernphase abgeschlossen sein, also eines der Kriterien für bereits früher gelesene Codewörter mit geforderter Häufigkeit oder ununterbrochener Wiederholung insbesondere bis zum aktuellen Leseversuch hin erfüllt sein. Wenn in einer Anwendung Codes keine sich wiederholenden Abschnitte aufweisen, kann es sein, dass die an sich mögliche Vorkorrektur lange nicht oder gar nicht zum Einsatz kommt. Sie wäre in einer solchen Anwendung auch kaum in der Lage, einen Gewinn zu bringen. Mit dem schwächsten Kriterium, dass ein Codewort schon bekannt ist, wenn es irgendwann einmal gelesen wurde, lässt sich die Einlernphase auch dann sehr schnell erfolgreich beenden, aber dieses Vorwissen ist so schwach, dass damit bei stark variierenden Codes kaum eine Verbesserung der Leserate zu erwarten ist. Deshalb sollte bevorzugt das Kriterium für bekannte Codewörter mit Rücksicht auf die in der Anwendung auftretenden Codes gewählt werden.

Die Erfindung wird nachstehend auch hinsichtlich weiterer Merkmale und Vorteile beispielhaft anhand von Ausführungsformen und unter Bezug auf die beigefügte Zeichnung näher erläutert. Die Abbildungen der Zeichnung zeigen in:
- Fig. 1: eine schematische dreidimensionale Übersichtsdarstellung der beispielhaften Montage eines Codelesers über einem Förderband, auf dem Objekte mit zu lesenden Codes gefördert werden;
- Fig. 2: eine beispielhafte Darstellung einiger gelesener Codes mit sich wiederholenden Codeabschnitten;
- Fig. 3: eine tabellarische Darstellung zur Erläuterung, wie sich wiederholende Codeabschnitte aufgefunden werden können;
- Fig. 4: eine tabellarische Darstellung von durch Wiederholung bekannten Codewörtern und deren zugehörige Codeinhalte; und

- Fig. 5: eine tabellarische Darstellung einer Vorkorrektur eines zuvor nicht lesbaren Codes anhand durch Wiederholung bekannter Codewörter mit anschließendem erfolgreichem Leseversuch.

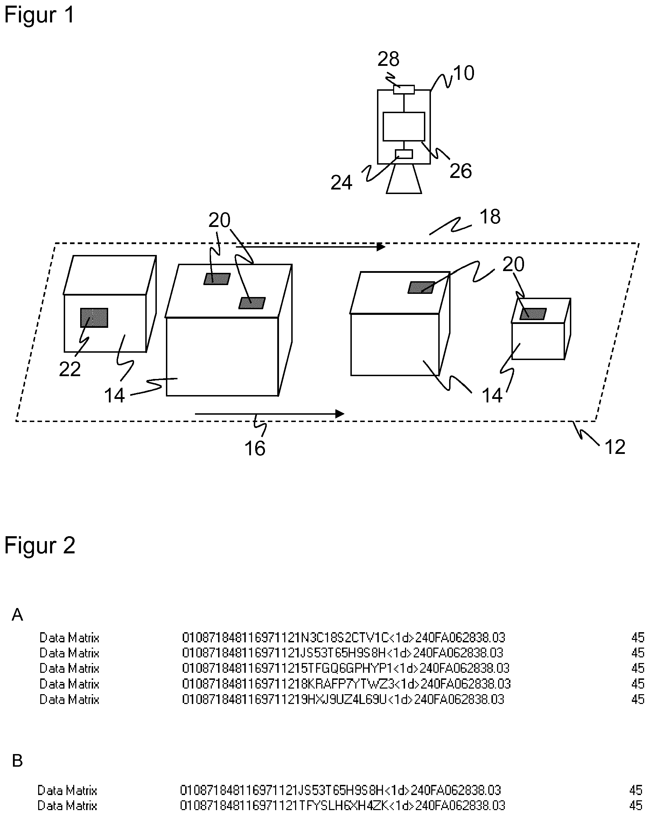

Figur 1 zeigt einen optoelektronischen Codeleser 10, der über einem Förderband 12 montiert ist, welches Objekte 14, wie durch den Pfeil 16 angedeutet, durch den Erfassungsbereich 18 des Codelesers 10 fördert. Die Objekte 14 tragen an ihren Außenflächen Codebereiche 20, die von dem Codeleser 10 erfasst und ausgewertet werden. Diese Codebereiche 20 können von dem Codeleser 10 nur dann erkannt werden, wenn sie auf der Oberseite oder zumindest von oben sichtbar angebracht sind. Daher kann abweichend von der Darstellung in Figur 1 zum Lesen eines etwa seitlich oder unten angebrachten Codes 22 eine Mehrzahl von Codelesern 10 aus verschiedenen Richtungen montiert sein, um eine sogenannte Omnilesung aus allen Richtungen zu ermöglichen. Die Anordnung der mehreren Codeleser 10 zu einem Lesesystem erfolgt in der Praxis meist als Lesetunnel. Diese stationäre Anwendung des Codelesers 10 an einem Förderband ist in der Praxis sehr häufig. Die Erfindung bezieht sich aber auf das Lesen von Codes beziehungsweise den Codeleser 10 selbst, so dass dieses Beispiel nicht einschränkend verstanden werden darf.

Der Codeleser 10 erfasst mit einem Lichtempfänger 24 Bilddaten der geförderten Objekte 14 und der Codebereiche 20, die von einer Auswertungseinheit 26 mittels Bildauswertung und Decodierverfahren weiterverarbeitet werden. Es kommt für die Erfindung nicht auf das konkrete Bildgebungsverfahren an, so dass der Codeleser 10 nach irgendeinem an sich bekannten Prinzip aufgebaut sein kann. Beispielsweise wird jeweils nur eine Zeile erfasst, sei es mittels zeilenförmigem Bildsensor oder einem Scanverfahren, und die Auswertungseinheit fügt die im Laufe der Förderbewegung erfassten Zeilen zu den Bilddaten zusammen. Mit einem matrixförmigen Bildsensor lässt sich schon in einer Aufnahme ein größerer Bereich erfassen, wobei auch hier das Zusammenfügen von Aufnahmen sowohl in Förderrichtung als auch quer dazu möglich ist. Über eine Schnittstelle 28 gibt der Codeleser 10 Informationen aus, wie gelesene Codes oder Bilddaten.

Nachstehend wird unter Bezugnahme auf die Figuren 2 bis 5 eine Verbesserung des Decodierverfahrens, mit dem der Codeleser 10 Codes liest, durch eine Vorkorrektur erläutert. Vorzugsweise erfolgt dies in der Auswertungseinheit 26. Ebenso ist aber denkbar, Bilddaten oder Zwischenergebnisse über die Schnittstelle 28 auszugeben und zumindest einen Teil der Decodierung in ein übergeordnetes System auszulagern, wie einen Steuerungsrechner, ein Netzwerk oder eine Cloud. Vorverarbeitungen der Bilddaten zu Segmentierung und zum Auffinden von Codebereichen 20 sowie die Decodierung an sich werden als bekannt vorausgesetzt und nicht beschrieben. Außerdem wird die Erfindung am Beispiel des Codelesens mit Reed-Solomon-Korrektur erklärt. Dabei geht es nicht um das konkrete Reed-Solomon-Verfahren, sondern um dessen Fähigkeit, bis zu einer gewissen Anzahl von Fehlern Codewörter korrigieren zu können. Andere Prüf- oder Korrekturverfahren sind genauso denkbar, sofern der zu lesende Codetyp sie unterstützt. In manchen Ausführungsformen genügt es, wenn das Prüfverfahren keine Fehler korrigieren kann, sondern nur den gelesenen Codeinhalt validiert.

Figur 2 zeigt eine beispielhafte Darstellung einiger gelesener Codes, hier DataMatrix-Codes der Codelänge 45. Eine solche Folge von Codes wird auch als Historie bezeichnet. In vielen realen Anwendungen sind die gelesenen Codes nicht völlig verschieden voneinander, sondern es gibt vielmehr immer wiederkehrende Anteile. Beispiele sind untereinander ähnliche Waren mit Code, etwa Zigarettenpackungen, eine im Code enthaltene Herstellerkennung innerhalb einer Anlage, Seriennummern, die nur am Ende heraufgezählt werden, und viele weitere.

Die in Figur 2 gezeigten Codes stammen aus einer Bildsequenz A und einer Stunden später aufgenommenen Bildsequenz B. Offensichtlich gibt es in der Anwendung, in der die Codes gelesen wurden, sich wiederholende Zeichen, die sich hier auf zwei Blöcke aufteilen: 010871848116971121 und <1d>240FA062838.03. Dabei sind hier decodierte Zeichen gezeigt, nicht die Codewörter, aus denen die Zeichen gewonnen werden. Wenn man die sich verändernden Zeichen mit "?" markiert, so können alle gelesenen Codes in dieser Form dargestellt werden:
010871848116971121?????????????<1d>240FA062838.03

Die 18+15 festen Zeichen bilden in diesem Fall gegenüber den 13 variablen Zeichen sogar die Mehrheit.

Die erfindungsgemäße Vorkorrektur macht sich das Vorwissen über sich wiederholende Codewörter und entsprechende Zeichen zu Nutze. Solche Codewörter werden für den weiteren Betrieb für ihre Position als bekannt vorausgesetzt.

In einer bevorzugten Ausführungsform wird der herkömmliche Lesebetrieb fortgesetzt, bis beim Leseversuch eines Codes ein Lesefehler auftritt. In diesem Code sind zu viele Codewörter von Defekten oder sonstigen Störungen betroffen, und daher reicht die Kapazität der Reed-Solomon-Korrektur nicht aus. Dann wird an mindestens einer Position ein Codewort des zu lesenden Codes durch das bekannte Codewort ersetzt, entweder irgendwo oder vorzugsweise, damit die Vorkorrektur auch etwas bewirkt, gezielt an einer Position, wo das bisherige Decodierergebnis von dem bekannten Codewort abweicht. Anschließend wird erneut ein Leseversuch mit Reed-Solomon-Korrektur unternommen. Wenn die Vorkorrektur mit dem bekannten Codewort an dessen Position das richtige Codewort eingesetzt hat, reicht jetzt möglicherweise die Korrekturkapazität der Reed-Solomon-Korrektur aus, um den ganzen Code zu lesen. Ansonsten kann ein weiterer Versuch mit Ersetzungen durch andere oder mehr für ihre jeweilige Position bekannte Codewörter folgen.

Alternativ wird gar nicht erst versucht, den ganzen Code mit Reed-Solomon-Korrektur zu lesen. Es werden von Vorneherein einige oder alle Positionen mit einem jeweils für diese Position bekannten Codewort ersetzt. Im obigen Beispiel müssen dann nur noch die vergleichsweise wenigen Codewörter decodiert werden, die den "?" entsprechen, und es wird erheblich weniger wahrscheinlich, dass die Kapazität der Reed-Solomon-Korrektur überschritten ist. Dieses Vorgehen sollte vorzugsweise nur dann gewählt werden, wenn sich in den Codes die bekannten Codewörter mit entsprechend hoher Wahrscheinlichkeit an deren jeweiligen Positionen befinden und auch das Vorwissen über diese Tatsache entsprechend sicher ist.

Nach beiden Vorgehensweisen kann die Vorkorrektur also dafür sorgen, dass auch ein ansonsten nicht lesbarer Code der Reed-Solomon-Korrektur doch wieder zugänglich wird, und damit die Leserate erhöhen.

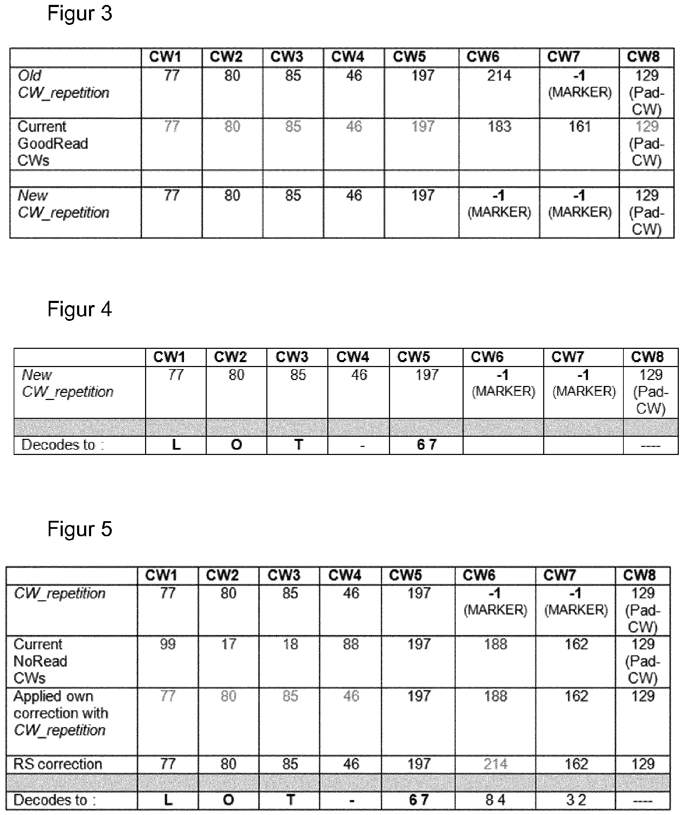

Figur 3 zeigt eine tabellarische Darstellung, anhand derer beispielhaft eine Lernphase zum Einlernen von sich wiederholende Codeabschnitten beschrieben wird, um für jeweilige Positionen bekannte Codewörter aufzufinden.

Ziel ist dabei herauszufinden, ob in der derzeitigen Anwendungssituation wiederkehrende Datencodewortfolgen vorkommen. Ist das der Fall, werden wiederholte Codewörter an ihren jeweiligen Positionen als bekannt eingelernt und für die Vorkorrektur verwendet.

Die Tabelle in Figur 3 zeigt ein Beispiel für den Codetype DataMatrix mit der Symbolgröße 14x14 und der Datencodewortlänge 8. In der Variablen CW_repetition sind für die acht Positionen CW1...CW8 der Datencodewörter die bisher bekannten Codewörter abgelegt. Nicht wiederholte Positionen sind mit einem speziellen Marker gekennzeichnet, hier -1. Bleibt auch am Ende der Einlernphase ein solcher Marker stehen, so entspricht das den obigen "?". Dabei ist zu beachten, das oben bei den "?" decodierte Zeichen stehen, CW-repetition jedoch Codewörter enthält. Das ist letztlich ineinander überführbar, aber nicht dasselbe. Ein Codewort kann für zwei Zeichen stehen (Beispiel:CW5=197 entspricht den zwei Zeichen "67"), umgekehrt können zwei Codewörter für ein Kanji-Zeichen stehen. Deshalb sind die Positionen in den decodierten Zeichen auch nicht zwingend identisch mit denjenigen der Codewörter, auf die sich Positionen im Ausführungsbeispiel und für CW_repetition beziehen.

In der obersten Zeile der Tabelle in Figur 3 ist der bisherige Wert (old) von CW_repetition eingetragen. Die zweite Zeile zeigt einen aktuell gelesenen Code, der damit verglichen wird. In der dritten Zeile steht der mit diesem aktuellen Code modifizierte Wert (new) von CW_repetition.

Für den beispielhaft aktuell gelesenen Code der zweiten Zeile stimmt an den Positionen CW1..CW5 sowie CW8 das jeweils gelesene Codewort mit dem bisher wiederholten Codewort gemäß CW_repetition der ersten Zeile überein, und deshalb werden sie in die dritte Zeile übernommen. An der Position CW6 ergibt sich eine Abweichung, so dass hier nun der Marker -1 für ein nicht wiederholtes Codewort gesetzt wird. An der Position CW7 gab es bisher schon keine Wiederholung, und das wird so übernommen.

Initialisiert wird CW_repetition beispielsweise mit einem ersten erfolgreich gelesenen Code. Während der Lernphase wird die Reed-Solomon-Korrektur vorzugsweise schon verwendet, die Vorkorrektur dagegen noch nicht, da ja noch keine bekannten Codewörter eingelernt sind. Da für das Einlernen nur erfolgreich gelesene Codes genutzt werden, spielt es letztlich auch keine Rolle, mit welchem konkreten Leseverfahren diese Informationen gewonnen werden.

Nach einer gewissen Anzahl von erfolgreich gelesenen Codes, mit denen CW_repetition modifiziert wird, ist das Einlernen abgeschlossen. Diese Anzahl ist ein Parameter des Verfahrens, der das geforderte Vertrauen in die für ihre jeweiligen Positionen bekannten Codewörter widerspiegelt, und kann auch Bedingungen unterliegen, etwa dass eine bestimmte Anzahl von Codes gelesen werden muss, bei denen sich CW_repetition nicht mehr ändert.

Das beschriebene Vorgehen verlangt, dass sich ein Codewort an einer Position während des gesamten Einlernens wiederholen muss, um als bekannt zu gelten. Es sind auch andere Kriterien denkbar. Beispielsweise kann CW_repetition auch ein Feld für mehrere Codewörter je Position sein, und es wird gezählt, wie oft diese Codewörter während des Einlernens vorkommen, insbesondere ununterbrochen nacheinander. Codewörter gelten dann nicht nur als bekannt, wenn sie stets an ihrer Position zu finden waren, sondern schon ab einer gewissen Anzahl oder Häufigkeit. Dabei kann jeweils nur das häufigste Codewort je Position als bekannt eingelernt werden. Es ist aber auch denkbar, mehrere am häufigsten vorkommende Codewörter für mehrere Versuche einer Vorkorrektur mit verschiedenen Hypothesen zu verwenden, bei denen die Kandidaten für bekannte Codewörter durchprobiert werden. Offensichtlich ist bei solchen schwächeren Kriterien das Vertrauen in das Vorwissen über bekannte Codewörter geringer, und bei mehreren Versuchen einer Vorkorrektur gibt es auch Auswirkungen auf die Laufzeit. Dafür kommen mehr Anwendungen in Betracht, in denen das Verfahren angewandt werden kann.

Nach Abschluss der Einlernphase ist in der Variablen CW_repetition erkannt, ob in der vorliegenden Anwendungssituation zumindest ein sich widerholendes Datencodewort entsprechend dem vorgegebenen Kriterium existiert. Ist das der Fall, kann anschließend die Vorkorrektur in einer Betriebs- oder Auswertephase genutzt werden.

Die bekannten Codewörter müssen im Übrigen nicht zwingend eingelernt werden. Das entsprechende Vorwissen kann auch auf andere Weise gewonnen werden, etwa durch Parametrierung oder Kommunikation mit einer Datenbank eines übergeordneten Systems, in dem der Codeleser 10 eingesetzt ist.

Figur 4 zeigt als Ausgangspunkt beispielhafte Werte der Variablen CW_repetition für die Vorkorrektur samt deren Decodierung. Das Einlernverfahren, das grundsätzlich parallel zum üblichen Betrieb ablaufen kann, ist nun abgeschlossen, das geforderte Kriterium für CW_repetition demnach erfüllt. Das System umfasst vorzugsweise ein Flag, mit dem angezeigt wird, dass CW_repetition verwendet werden darf und nicht mehr eingelernt wird.

Figur 5 ist eine tabellarische Darstellung eines Leseversuchs mit Vorkorrektur. Zu diesem Zeitpunkt, nach dem Einlernen, sind allgemeine Codeinformationen wie Datencodewortlänge, Symbolgröße und Codetyp bekannt. Es ist denkbar, dass der Codeleser 10 eine jeweilige Vorkorrektur für verschiedene Codewortlängen, Symbolgrößen und Codetypen einlernt und je nach aktuell zu lesendem Code einsetzt. Die Struktur der Tabelle ist die gleiche wie in den Figuren 3 und 4, und die erste Zeile zeigt nochmals die Werte von CW_repetition. Es steht also an den Positionen CW1...CW5 und CW8 Vorwissen in Form von für diese Positionen bekannten Codewörtern zur Verfügung. Selbstverständlich kann der Anteil der bekannten Codewörter in anderen Fällen größer oder kleiner sein.

In der zweiten Zeile ist das Ergebnis eines Leseversuchs eines aktuell zu lesenden Codes dargestellt, vorzugsweise mittels Reed-Solomon-Korrektur. Der Decoder hat einen Lesefehler (NoRead, Reed-Solomon-Error) zurückgegeben, weil die Fehlerkorrekturkapazität überschritten wurde.

Im Rahmen der Vorkorrektur wird nun zumindest eines der abgespeicherten, sich wiederholenden Datencodewörter von CW_repetition in der ersten Zeile der Tabelle verwendet, um damit das an dieser Position gelesene Datencodewort der zweiten Zeile zu überschreiben. Das Ergebnis dieser Vorkorrektur ist in der dritten Zeile der Tabelle eingetragen. Sofern nur eines oder wenige der aktuell gelesenen Datencodewörter mit Datencodewörtern aus CW_repetition ersetzt werden, sollte dies an Stellen geschehen, an denen auch ein Unterschied besteht. Das wären in Figur 5 die Positionen CW1...CW4. Bei einem Ersetzen nur an den Positionen CW5 beziehungsweise CW8 würde die Vorkorrektur effektiv leerlaufen. Es ist auch denkbar, mehrere Versuche mit Vorkorrekturen an unterschiedlichen Positionen durchzuführen. Eine sehr einfache und erfolgversprechende Möglichkeit besteht darin, direkt ohne Vergleich in einem Schritt eine Vorkorrektur mit allen bekannten Codewörtern vorzunehmen. Es werden also an den mit "-1" beziehungsweise "?" markierten Positionen mit variablem Inhalt die Codewörter des aktuell gelesenen Codes der zweiten Zeile, an den übrigen Positionen mit wiederholtem Inhalt die Codewörter aus CW_repetition der ersten Zeile übernommen.

Nach der Vorkorrektur der Datencodewörter wird nun erneut die Reed-Solomon-Korrektur angewandt, um auch Fehler an den Positionen mit sich nicht wiederholendem Inhalt zu korrigieren. Wenn es durch die Vorkorrektur gelungen ist, zuerst falsch gelesene Codewörter durch richtige Codewörter zu ersetzen, ist dadurch ein Teil der Fehlerkorrekturkapazität freigeworden. In dem Beispiel der Figur 5, in dem das Ergebnis der Reed-Solomon-Korrektur in der vierten Zeile der Tabelle eingetragen ist, war gar keine weitere Korrektur erforderlich. Somit wird die Leserate durch zwei Stufen verbessert: Es werden in der Vorkorrektur nicht lesbare Codewörter aus Vorwissen ersetzt. Außerdem wird dadurch ermöglicht, andere Fehler im Rahmen der Reed-Solomon-Korrektur zu korrigieren.

Die Reed-Solomon-Korrektur hätte auch erkannt, wenn eine der Ersetzungen durch die Vorkorrektur für den zu lesenden Code nicht zutrifft. An dieser Stelle hätte dann die Vorkorrektur keinen Nutzeffekt, sondern die Fehlerkorrekturkapazität weiterhin beansprucht. Das bedeutet dann, dass das Codewort an der betreffenden Position entgegen der Annahme nicht mit CW_repetition übereinstimmt, was vorzugsweise die gleichen Auswirkungen auf CW_repetition nach sich zieht, wie wenn sich während des Einlernens ein Codewort nicht wiederholt.

Möglicherweise ist trotz der Vorkorrektur die Fehlerkorrekturkapazität noch überschritten. Das kann daran liegen, dass die Vorkorrektur an mindestens einer Position ein Codewort ersetzt hat, das dort im aktuell zu lesenden Code nicht hingehört, also keinen Fehler eliminiert oder sogar einen zusätzlichen Fehler eingeführt hat. Denkbar ist auch, dass die Vorkorrektur völlig richtig war, jedoch im variablen Teil des Codes immer noch zu viele Fehler enthalten sind. In solchen Fällen bleibt es auch nach beiden Stufen Vorkorrektur und Reed-Solomon-Korrektur bei einem Lesefehler.

Die letzte Zeile der Tabelle in Figur 5 zeigt noch das Decodierergebnis für den nach zweifachem Korrekturverfahren gelesenen Code.

Auch während des Betriebs mit Vorkorrektur wird CW_repetition vorzugsweise wie in der Einlernphase weiter aktualisiert. Dadurch kann erkannt werden, wenn sich bisher wiederholende Codewörter an ihren jeweiligen Positionen nun doch verändern. In einem solchen Fall sollte dann vorzugsweise zumindest für die betroffenen Positionen die Einlernphase für CW_repetition neu beginnen und bis zu deren Abschluss keine Vorkorrektur mehr vorgenommen werden.

Die Variable CW_repetition und damit im Zusammenhang stehende Werte können über die Schnittstelle 28 ausgegeben werden. Das ermöglicht eine Diagnose und ist beispielsweise nützlich, wenn man im Nachhinein oder zu Simulationszwecken die Lesesituation nachstellen möchte.

Das erfindungsgemäße Verfahren zum Lesen von Codes mit Vorkorrektur erhöht die Leserate in Anwendungen, in denen es einen häufiger wiederkehrenden Anteil von Datencodewort-Sequenzen gibt. Je nach sich wiederholendem Anteil der Codes, verglichen mit dem variablen Anteil, ermöglicht dies, Codes mit Störungen oder Defekten sogar noch weit über die Fehlerkorrekturkapazität der Reed-Solomon-Korrektur hinaus zu lesen.

## Patentansprüche

1. Verfahren zum Lesen eines optischen Codes (20), der eine Vielzahl von Codewörtern aufweist, wobei Bilddaten mit dem optischen Code (20) aufgenommen und ausgewertet werden, um die Codewörter auszulesen, und wobei mit einem Prüfverfahren festgestellt wird, ob der Code richtig gelesen ist, wobei in einer Vorkorrektur an mindestens einer Position des Codes (20) ein Codewort durch ein für diese Position bekanntes Codewort ersetzt wird und das Prüfverfahren nach der Vorkorrektur durchgeführt wird,
**dadurch gekennzeichnet,**
**dass** die bekannten Codewörter und deren Positionen wiederkehrenden Datencodewortfolgen in einer derzeitigen Anwendungssituation entsprechen, wobei die bekannten Codewörter parametriert, von einer Datenbank eines übergeordneten System vorgegeben oder aus einer Historie von gelesenen Codes (20) eingelernt werden.

2. Verfahren nach Anspruch 1,
wobei die Vorkorrektur erst durchgeführt wird, wenn zuvor laut Prüfverfahren der Code (20) nicht gelesen werden konnte.

3. Verfahren nach Anspruch 1 oder 2,
wobei das Prüfverfahren Lesefehler korrigiert.

4. Verfahren nach Anspruch 3,
wobei das Prüfverfahren eine Reed-Solomon-Fehlerkorrektur aufweist.

5. Verfahren nach Anspruch 3 oder 4,
wobei für den Fall, dass das Prüfverfahren ein in der Vorkorrektur ersetztes bekanntes Codewort an einer Position korrigieren muss, dieses bekannte Codewort für diese Position nicht länger als bekannt angesehen wird.

6. Verfahren nach einem der vorhergehenden Ansprüche,
wobei ein Codewort als für eine Position bekannt angenommen wird, wenn es in der Historie mindestens einmal an der Position vorkommt.

7. Verfahren nach einem der vorhergehenden Ansprüche,
wobei ein Codewort als für eine Position bekannt angenommen wird, wenn es in der Historie mindestens n-mal an der Position vorkommt.

8. Verfahren nach einem der vorhergehenden Ansprüche,
wobei ein Codewort als für eine Position bekannt angenommen wird, wenn es sich in der Historie mindestens n-mal an der Position wiederholt.

9. Verfahren nach einem der vorhergehenden Ansprüche,
wobei ein Codewort als für eine Position bekannt angenommen wird, wenn direkt zuvor ein anderer Code (20) mit diesem Codewort an dieser Position gelesen wurde.

10. Verfahren nach einem der vorhergehenden Ansprüche,
wobei die Vorkorrektur nur durchgeführt wird, wenn an mindestens einer Position ein Codewort bekannt ist.

11. Optoelektronischer Codeleser (10) mit mindestens einem Lichtempfangselement (24) zur Erzeugung von Bilddaten aus Empfangslicht und mit einer Auswertungseinheit (26), in der ein Verfahren zum Lesen von optischen Codes (20) nach einem der vorhergehenden Ansprüche implementiert ist.

## Claims

1. A method of reading an optical code (20) having a plurality of code words,
wherein image data having the optical code (20) are recorded and evaluated to read out the code words, and wherein it is determined by a test process whether the code is read correctly, wherein in a pre-correction a code word at at least one position of the code (20) is replaced with a code word known for this position and wherein the test process is carried out after the pre-correction,
**characterized in that** the known code words and their positions correspond to repeating data code word sequences in a current application situation, wherein the known code words are parametrized, set by a data base of a higher level system or taught from a history of read codes (20).

2. The method in accordance with claim 1,
wherein the pre-correction is only carried out when the code (20) could not be read previously according to the test process.

3. The method in accordance with claim 1 or 2,
wherein the test process corrects reading errors.

4. The method in accordance with claim 3,
wherein the test process comprises a Reed-Solomon error correction.

5. The method in accordance with any of the preceding claims,
wherein, for the case that the test process has to correct a known code word at a position replaced in the pre-correction, this known code word for this position is no longer considered as known.

6. The method in accordance with any of the preceding claims,
wherein a code word is assumed as known for a position when it occurs at least once at the position in the history.

7. The method in accordance with any of the preceding claims,
wherein a code word is assumed as known for a position when it occurs at least n times at the position in the history.

8. The method in accordance with any of the preceding claims,
wherein a code word is assumed as known for a position when it repeats at least n times at the position in the history.

9. The method in accordance with any of the preceding claims,
wherein a code word is assumed as known for a position when another code (20) having this code word has been directly previously read at this position.

10. The method in accordance with any of the preceding claims,
wherein the pre-correction is only carried out when a code word is known at at least one position.

11. An optoelectronic code reader (10) having at least one light reception element (24) for generating image data from received light and having an evaluation unit (24) in which a method of reading optical codes (20) according to any of the preceding claims is implemented.

## Revendications

1. Procédé de lecture d'un code optique (20) comprenant une multitude de mots de code, dans lequel des données d'image sont enregistrées et évaluées avec le code optique (20) pour lire les mots de code, et dans lequel par un processus de vérification il est déterminé si le code est lu correctement, et lors d'une précorrection, à au moins une position du code (20), un mot de code est remplacé par un mot de code connu pour cette position et le processus de vérification est effectué après la précorrection,
**caractérisé en ce que**
les mots de code connus et leurs positions correspondent à des séquences de mots de code de données récurrentes dans une situation d'application courante, les mots de code connus étant paramétrés, définis par une base de données d'un système de niveau supérieur ou appris d'un historique de codes (20) lus.

2. Procédé selon la revendication 1,
dans lequel la précorrection n'est effectuée que lorsque le code (20) n'a pas pu être lu auparavant selon le processus de vérification.

3. Procédé selon la revendication 1 ou 2,
dans lequel le processus de vérification corrige des erreurs de lecture.

4. Procédé selon la revendication 3,
dans lequel le processus de vérification comprend une correction d'erreur de Reed-Solomon.

5. Procédé selon la revendication 3 ou 4,
dans lequel au cas où le processus de vérification doit corriger à une position un mot de code connu remplacé lors de la précorrection, ce mot de code connu n'est plus considéré comme connu pour cette position.

6. Procédé selon l'une des revendications précédentes,
dans lequel un mot de code est supposé comme connu pour une position lorsqu'il apparaît au moins une fois à la position dans l'historique.

7. Procédé selon l'une des revendications précédentes,
dans lequel un mot de code est supposé comme connu pour une position lorsqu'il apparaît au moins n fois à la position dans l'historique.

8. Procédé selon l'une des revendications précédentes,
dans lequel un mot de code est supposé comme connu pour une position lorsqu'il se répète au moins n fois à la position dans l'historique.

9. Procédé selon l'une des revendications précédentes,
dans lequel un mot de code est supposé comme connu pour une position lorsqu'immédiatement auparavant, un autre code (20) avec ce mot de code à cette position a été lu.

10. Procédé selon l'une des revendications précédentes,
dans lequel la précorrection n'est effectuée que lorsqu'un mot de code est connu à au moins une position.

11. Lecteur de code optoélectronique (10) comportant au moins un élément récepteur de lumière (24) pour générer des données d'image à partir de la lumière de réception, et comportant une unité d'évaluation (26) dans laquelle est implémenté un procédé de lecture de codes optiques (10) selon l'une des revendications précédentes.
